# EUROPÄISCHE PATENTANMELDUNG

(11) **EP 2 141 745 A2**
(43) Veröffentlichungstag der Anmeldung: **06.01.2010**
(21) Anmeldenummer: 09163223.2
(22) Anmeldetag: 19.06.2009
(51) Int. Cl.: H01L 31/024, H01L 31/042, F24J 2/04, F24J 2/26

(54) **Verfahren und Vorrichtung zur Herstellung eines Solarmoduls und solches Solarmodul**

(30) Priorität: 04.07.2008 DE 102008031436; 16.07.2008 DE 102008064620
(71) Anmelder: Krauss-Maffei Kunststofftechnik GmbH, 80997 München (DE)
(72) Erfinder: Kern, Hans-Jürgen, 83093, Bad Endorf (DE)
(74) Vertreter: Zollner, Richard

(57) **Zusammenfassung**

Die vorliegende Erfindung betrifft Verfahren und eine Vorrichtung zur Herstellung eines Solarmoduls sowie ein solches Solarmodul. Gemäß dem Verfahren wird zunächst eine Trägerstruktur ausgebildet, dann eine Temperiereinrichtung in die oder auf die Trägerstruktur ein- oder aufgebracht, und anschließend ein Zwischenprodukt mit Photovoltaik-Zellen auf die Trägerstruktur aufgebracht oder die Temperiereinrichtung eingegossen, derart, dass die Temperiereinrichtung einstrahlungsmäßig hinter den Photovoltaik-Zellen angeordnet sind.

## Beschreibung

Die vorliegende Erfindung betrifft ein Verfahren sowie eine Vorrichtung zur Herstellung eines Solarmoduls sowie ein solchermaßen hergestelltes Solarmodul, bei der Photovoltaik-Zellen eingegossen und auf einer Trägerstruktur aufgebracht sind.

Es ist bereits bekannt, Solarmodule herzustellen, bei denen Photovoltaik-Zellen in ein Gießsystem, insbesondere in einem Polyurethanmaterial eingebettet werden. Eine solche Lehre ist aus der DE 101 01 770 A1 bekannt. Dabei wird das Solarmodul zumindest auf der Frontseite mit einem transparenten Polyurethan versehen. Polyurethan bietet nämlich im Vergleich zu anderen Materialien eine hohe Witterungsstabilität, den Vorteil geringer Materialkosten sowie eine niedrige Dichte. Im Übrigen wird auch auf die DE 20 2006 015928 hingewiesen.

Bei Photovoltaik-Zellen ist es bekannt, dass diese in einem bestimmten Temperaturbereich ihren größten Wirkungsgrad haben. Wird dieser Temperaturbereich überschritten, sinkt der Wirkungsgrad wieder.

Aufgabe der vorliegenden Erfindung ist es, ein Solarmodul so herzustellen und ein solches Solarmodul anzugeben, welches in einem möglichst guten Wirkungsgradbereich arbeiten kann.

Diese Aufgabe wird verfahrensmäßig durch die im Anspruch 1 genannten Merkmale und vorrichtungsmäßig durch die in den unabhängigen Ansprüchen 5 und 6 genannten Merkmale gelöst.

Demgemäß ist ein Gedanke der vorliegenden Erfindung darin zu sehen, dass in die der Solar-Zellen zugewandten Oberfläche der Trägerstruktur oder auf der Trägerstruktur Kühlkanäle eingearbeitet oder aufgebracht sind, durch die beim späteren Betrieb ein Temperierfluid hindurchgeleitet werden kann. Damit ist es möglich, das Solarmodul in einem für den Wirkungsgrad der Einheit günstigen Temperaturbereich zu betreiben. Im optimalen Fall kann durch das Temperierfluid Wärme abgeführt werden, welche (z.B. nach Art eines Solarkollektors) wiederum zu Heizzwecken verwendet wird. Gemäß einer Ausführungsform können in der Oberfläche der Trägerstruktur Kanäle oder Nuten eingearbeitet sein, was beispielsweise im Tiefziehverfahren durchgeführt werden kann. In diese Kanäle sind dünne aber fluiddichte Rohre eingebracht, welche im Wesentlichen bündig mit der Oberfläche der Trägerstruktur abschließen. Diese Rohre sind miteinander dicht verbunden und an den Austritts-Enden mit einem Zu- und einem Abfluss versehen. Beim Herstellprozess kann zunächst die entsprechende Trägerstruktur ausgebildet und die Rohre eingebracht werden. Dann wird wie oben beschrieben vorgegangen und beispielsweise das Zwischenprodukt aus Photovoltaik-Zellen und Polyurethan auf die entsprechend ausgebildete Trägerstruktur aufgebracht. Natürlich ist es möglich, diese Art der Temperierung auf vielfältige Weise zu realisieren. Ausschlaggebend ist lediglich, dass die Kühlung einstrahlungsmäßig hinter den Photovoltaik-Zellen angeordnet ist. Dabei könnten die Kühlkanäle auch ganz in das vernetzende Material eingegossen sein.

Überdies werden die Photovoltaik-Zellen vollständig in ein vernetzendes Material, beispielsweise ein Polyurethanmaterial eingehüllt. Dabei liegen bei einem ersten Überflutungsvorgang die Oberseiten der Photovoltaik-Zellen vollflächig auf einem Formwerkzeug oder einer Zellenträgerplatte auf. Durch einen solchen Schritt kann vermieden werden, dass beim Einbringvorgang des Polyurethanmaterials die Photovoltaik-Zellen durch die Druckbelastung beschädigt oder gar zerstört werden. Durch die vollflächige Auflage wird nicht nur das gesamte Photovoltaik-Element über seine ganze Fläche abgestützt. Es wird auch verhindert, dass das im ersten Schritt eingebrachte vernetzende Material an die Oberseite der Photovoltaik-Zellen gelangt. Zudem kann die Zellenträgerplatte bei Verwendung einer solchen in bestimmten Grenzen elastisch ausgebildet werden, um Druckungleichheiten auszugleichen. Überdies ist es bei Verwendung einer Zellenträgerplatte möglich, die Solar-Zellen samt Verdrahtung extern aufzulegen und die so hergestellte Anordnung gleichsam als Einsatz in das Formwerkzeug einzufügen. So können parallel verschiedene Zellenträgerplatten vorbereitet werden, die dann sukzessive eingelegt und in dem Formwerkzeug bearbeitet werden.

Nach dem Aufbringen des vernetzenden Materials auf die Rückseite der Photovoltaik-Zellen wird das so hergestellte Zwischenprodukt auf einer Trägerstruktur angeordnet, und zwar derart, dass die sich im Zwischenprodukt befindlichen Photovoltaik-Zellen nun mit ihrer Rückseite der Trägerstruktur zugewandt sind bzw. dass die Oberseite der Photovoltaik-Zellen der Trägerstruktur abgewandt ist. Dieser Verfahrensschritt kann dadurch erfolgen, dass das Zwischenprodukt auf die Trägerstruktur oder alternativ, dass die Trägerstruktur auf das Zwischenprodukt verbracht wird.

Nachfolgend wird das vollständige Überfluten der Vorder- und Oberseite der Photovoltaik-Zellen durchgeführt, wodurch man ein einheitliches Solarzellengebilde erhält. Dabei ist natürlich notwendig, dass zumindest die Oberseite der Solarzelle, also das im zweiten Schritt eingebrachte vernetzende oder Polyurethanmaterial, lichtdurchlässig ausgebildet ist. Dieser zweite Überflutungsvorgang kann durch einfaches Eingießen des niedrig viskosen, vernetzenden Materials in eine nach oben offene Aufnahme ausgeführt werden oder aber durch Ausbilden einer im wesentlichen gegenüber den Umgebung abgeschlossenen Kavität, wobei der Kavitätsspalt zumindest im wesentlichen die Dicke der Überflutungsschicht bestimmt und ein Formwerkzeug verwendet wird, von dem zumindest eine Fläche als Kavitätsfläche dient.

Weitere Merkmale und Vorteile der vorliegenden Erfindung sind in den Ansprüchen formuliert.

Die vorliegende Erfindung wird nunmehr anhand eines konkreten Ausführungsbeispiels und mit Bezug auf die beiliegenden Zeichnungen näher erläutert. Die Zeichnungen zeigen in
- Fig. 1: eine Ausführungsform eines nach dem erfindungsgemäßen Verfahren hergestellten Solarmoduls mit Kühlkanälen,
- Fig. 2: eine schematische Darstellung einer beispielhaften Vorrichtung zur Durchführung des Verfahrens zur Herstellung eines Solarmoduls, wobei die Vorrichtung noch unbefüllt ist,
- Fig. 3: eine schematische Darstellung der Vorrichtung aus Fig. 2, jedoch nun mit verschiedenen Befüllungen,
- Fig. 4: eine schematische Darstellung der zusammengeklappten Vorrichtung aus Fig. 2,
- Fig. 5: eine schematische Darstellung der gegenüber Fig. 4 um 180° gedrehten Vorrichtung,
- Fig. 6: eine schematische Darstellung der wieder geöffneten Vorrichtung aus Fig. 2,
- Fig. 7: eine schematische Darstellung eines in der Vorrichtung aus Fig. 2 fertiggestellten Solarmoduls,
- Fig. 8: eine schematische Darstellung einer zweiten Ausführungsform einer Vorrichtung zur Durchführung des Verfahrens zur Herstellung eines Solarmoduls, wobei die Vorrichtung wiederum unbefüllt, jedoch eine Zellenträgerplatte eingesetzt ist,
- Fig. 9: eine schematische Darstellung der Vorrichtung aus Fig. 8, jedoch nun mit verschiedenen Befüllungen in den beiden Formwerkzeughälften,
- Fig. 10: eine schematische Darstellung der zusammengeklappten Vorrichtung aus Fig. 8,

- Fig. 11: eine schematische Darstellung der wieder geöffneten Vorrichtung aus Fig. 2 mit entnommener Zellenträgerplatte und
- Fig. 12: eine schematische Darstellung einer wieder zusammengeklappten Vorrichtung aus Fig. 8 unter Ausbildung eines Kavitätsspaltes.

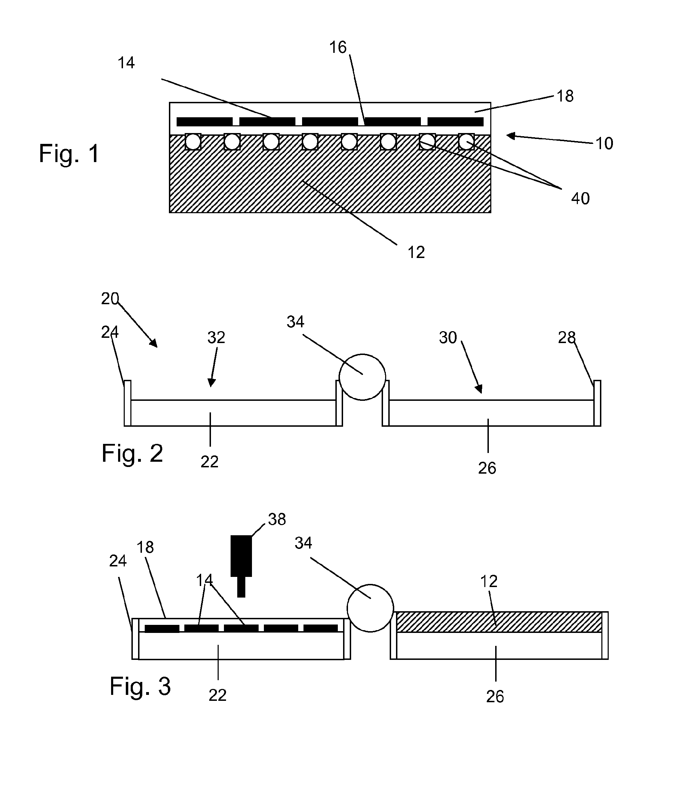

In Fig. 1 ist eine Ausführungsform eines fertigen Solar-Moduls dargestellt, bei dem in die der Solar-Zellen zugewandten Oberfläche der Trägerstruktur 12 Kühlkanäle 40 in Form von parallel zueinander verlaufenden Nuten eingearbeitet sind, wobei jeweils stirnseitig zwei benachbarte Nuten abwechselnd miteinander verbunden sind. In diese Nuten sind dünne Röhrchen eingesetzt, die fluiddicht miteinander verbunden sind und durch die beim späteren Betrieb ein Temperierfluid hindurchgeleitet werden kann. An den Austritts-Enden sind diese Röhrchen mit einem Zu- und einem Abfluss versehen, die so ausgestaltet sind, dass mehrere Solar-Module in Reihe oder parallel miteinander verbunden werden können. Die fluiddichten Röhrchen schließen im Wesentlichen bündig mit der Oberfläche der Trägerstruktur ab und sind mit dem Polyurethan eingegossen oder eingeschlossen.

Überdies sind in einer Polyurethanumhüllung 18 Photovoltaik-Zellen 14 vorgesehen, die untereinander mit Verbindungsleitungen 16 elektrisch verbunden sind. Die Photovoltaik-Zellen 14 sind von der Polyurethanumhüllung 18 vollständig ummantelt, wobei zumindest der Teil der Polyurethanschicht auf der Oberseite lichtdurchlässig ist. Die in die Polyurethanschicht 18 eingebetteten Photovoltaik-Zellen 14 sind aus Stabilitätsgründen auf einer Trägerstruktur 12 aufgebracht.

Bei der Herstellung dieses vorgenannten Solarmoduls 10 gemäß dem ersten Ausführungsbeispiel wird ein Formwerkzeug verwendet, wie es in Fig. 2 dargestellt ist. Dieses Formwerkzeug besitzt zwei Formwerkzeughälften, nämlich eine erste Formwerkzeughälfte 22 und eine zweite Formwerkzeughälfte 26, die über ein Gelenk 34 miteinander schwenkbar um eine Achse verbunden sind. Um diese Achse ist das Formwerkzeug aufklappbar oder auch verschließbar.

Die beiden Formwerkzeughälften 22, 26 besitzen an ihren Seiten nach oben geführte umlaufende Ränder, wobei in der Schnittdarstellung der Fig. 2 bei der ersten Formwerkzeughälfte zwei Ränder in Form einer Schalungsstruktur 24 und bei der zweiten Formwerkzeughälfte ebenfalls zwei Ränder mit der Schalungsstruktur 28 zu erkennen sind. Durch die Ränder 24, 28 ergeben sich bei den Formwerkzeugen 22, 26 Aufnahme 30 und 32.

Wie aus Fig. 3 zu erkennen ist, wird in der Aufnahme 30 der zweiten Formwerkzeughälfte eine Trägerstruktur, beispielsweise aus Polycarbonat eingebracht, die diese Aufnahme 30 vollständig ausfüllt.

Beim Herstellprozess kann zunächst die entsprechende Trägerstruktur ausgebildet und die Röhrchen eingebracht werden. Dann wird wie oben beschrieben vorgegangen und beispielsweise das Zwischenprodukt aus Photovoltaik-Zellen und Polyurethan auf die entsprechend ausgebildete Trägerstruktur aufgebracht.

In der zweiten Aufnahme 32 der ersten Formwerkzeughälfte 22 werden zunächst die Photovoltaik-Zellen 14 zusammen mit den dazwischen angeordneten Verbindungsleitungen 16 in der erforderlichen Weise positioniert, wobei die einzelnen Photovoltaik-Zellen 14 mit ihrer Oberseite vollflächig auf der ersten Formwerkzeughälfte 22 aufliegen. Nach der Anordnung der Photovoltaik-Zellen 14 in der ersten Formwerkzeughälfte 22 wird ein Polyurethanmaterial mittels eines Mischkopfes 38 in die Aufnahme 32 eingegossen oder aufgesprüht, welches sich aufgrund der geringen Viskosität gleichmäßig verteilt und nach Art einer Flüssigkeit die Photovoltaik-Zellen 14 umgibt. Aufgrund der vollflächigen Auflage der Photovoltaik-Zellen 14 auf der ersten Formwerkzeughälfte gelangt kein Polyurethanmaterial bei diesem Verfahrensschritt an die spätere Oberseite der einzelnen Photovoltaik-Zellen. Nunmehr härtet das Polyurethanmaterial zumindest im Wesentlichen aus, so dass eine ausreichende Festigkeit gegeben ist. Ausreichend kann auch sein, dass die Viskosität eines Gels durch einen Temperaturabfall erreicht wird.

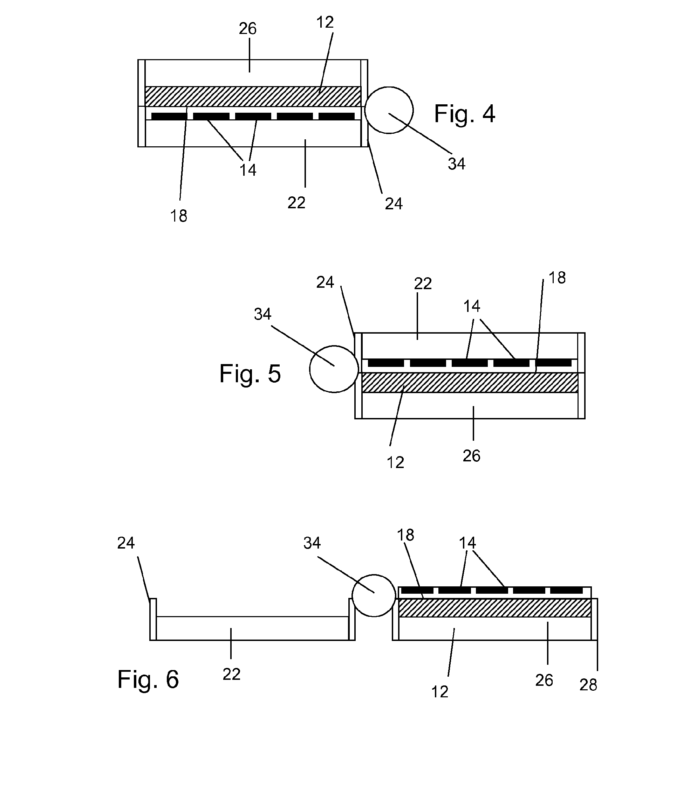

Nach diesem Schritt wird das Formwerkzeug zusammengeklappt, wie dies in Fig. 4 zu erkennen ist. Beim Vorgang des Zusammenklappens können die einzelnen Zellen in den Aufnahmen 30 und 32 mittels einer Vakuumeinrichtung gehalten werden. Diese Vakuumeinrichtung ist vorliegend nicht näher dargestellt.

Beim Zusammenklappen kommt die in Fig. 3 dargestellte Oberfläche des Zwischenproduktes, welches in der Aufnahme 32 der ersten Formwerkzeughälfte gebildet ist, auf der Trägerstruktur 12 zu liegen. Ist das Polyurethanmaterial noch nicht vollständig ausgehärtet, so ergibt sich nun eine gewisse Einbringung der Trägerstruktur 12 in das Polyurethanmaterial 18, wobei es zu einer formschlüssigen Verklebung kommt. Gleichzeitig wird bei diesem Verfahrensschritt des schwenkmäßigen Aufbringens die dazwischen befindliche Luft gleichmäßig ausgedrückt.

Nunmehr wird die gesamte Vorrichtung im 180° gedreht, wie in Fig. 5 zu erkennen ist.

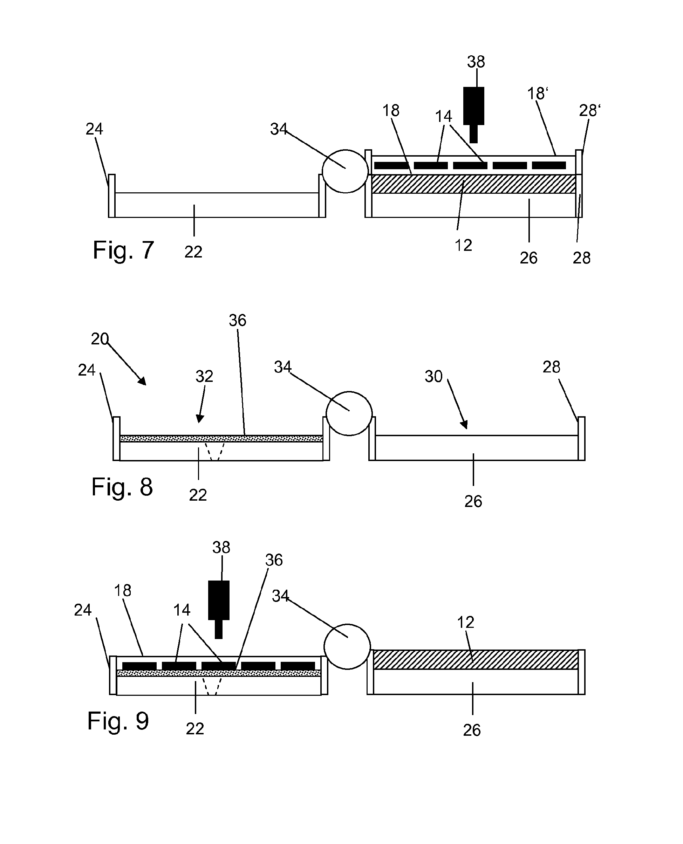

Im nächsten Schritt wird das Formwerkzeug wieder geöffnet, wie dies die Fig. 6 darstellt, wodurch nunmehr die noch nicht beschichteten Oberseiten der Photovoltaik-Zellen freiliegend sind. In einem anschließenden Schritt wird nun eine zusätzliche, umlaufende Schalungsstruktur 28' auf die erste Schalung 28 aufgebracht und diese somit nach oben verlängert (Fig. 7). Dadurch ergibt sich eine weiter nach oben geführte Aufnahme, in die nun ein weiteres Polyurethanmaterial (Schicht 18') eingegossen oder aufgesprüht wird.

Zumindest bei diesem Verfahrensschritt wird ein Polyurethanmaterial verwendet, welches im ausgehärteten Zustand lichtdurchlässig ist. Nach dem Eingießen dieses Polyurethanmaterials wird entweder ein Vakuum an die Oberfläche des so hergestellten Solarmoduls angelegt oder mit einem Heizstrahler die Oberfläche beaufschlagt, um eventuelle Lufteinschlüsse aus der Polyurethanoberfläche auszutreiben.

Beim Auf- und Einbringen der Polyurethanmaterialien können diese punkt- oder linienförmig aufgetragen werden, insbesondere mit einem Kleinmengenmischkopf.

Nach dem Aushärten des in dem letzten Verfahrensstand eingebrachten Polyurethanmaterials ist nun ein einheitliches Solarmodul gebildet, wie dies in Fig. 1 dargestellt ist. Dieses wird aus der Form entnommen und ist im Wesentlichen fertiggestellt.

Eine weitere Ausführungsform der Erfindung wird mit Bezug auf die Fig. 8 bis 12 beschrieben. Dabei bezeichnen gleiche Bezugszeichen gleiche oder ähnliche Konstruktionselemente.

Die Konstruktion in den Fig. 8 bis 12 unterscheidet sich dadurch von der vorher erläuterten Konstruktion, dass die Platte der Formwerkzeughälfte 22 etwas dünner ausgebildet ist und in diese Formwerkzeughälfte eine Zellenträgerplatte 36 eingelegt oder einlegbar ist (vgl. Fig. 9). Diese Zellenträgerplatte 36 deckt einerseits die Oberfläche der Formwerkzeughälfte 22 ab, andererseits bildet sie nunmehr die Auflage für die Solar-Zellenelemente14. Diese können in der Formwerkzeughälfte 22 oder bereits vorher zusammen mit der Verdrahtung auf die Zellenträgerplatte 36 aufgebracht werden. Damit kann die Zellenträgerplatte sozusagen als Einsatz ausgebildet sein, die entsprechend bestückt in die Formwerkzeughälfte eingesetzt wird. Überdies kann ein möglichst optimales Material für die Zellenträgerplatte verwendet werden. Einerseits kann es vorteilhaft sein, die Zellenträgerplatte griffig, aber auch zumindest geringfügig elastisch auszubilden. Andererseits kann ein Material verwendet werden, welches sich nicht mit dem einzufüllenden, vernetzenden Material verbindet.

Überdies kann mit der Zellenträgerplatte 36 eine Angussöffnung der Formwerkzeughälfte abgedeckt werden. Ferner ist es bei dieser Ausführungsform möglich, eine Oberflächenstruktur (z.B. Prismenstruktur) in die Wandung der Formwerkzeughälfte einzubringen, die später die Kavitätswand darstellt.

Beim Betrieb dieser Ausführungsform der Erfindung wird nun wie folgt vorgegangen:

Wie auch bei der vorherigen Ausführungsform wird nach dem Positionieren der Solar-Zellen auf der Zellenträgerplatte 36 in der Aufnahme 32 der ersten Formwerkzeughälfte 22 ein Polyurethan-Material in die Aufnahme 32 bündig mit dem oberen Rand der Schalung eingegossen.

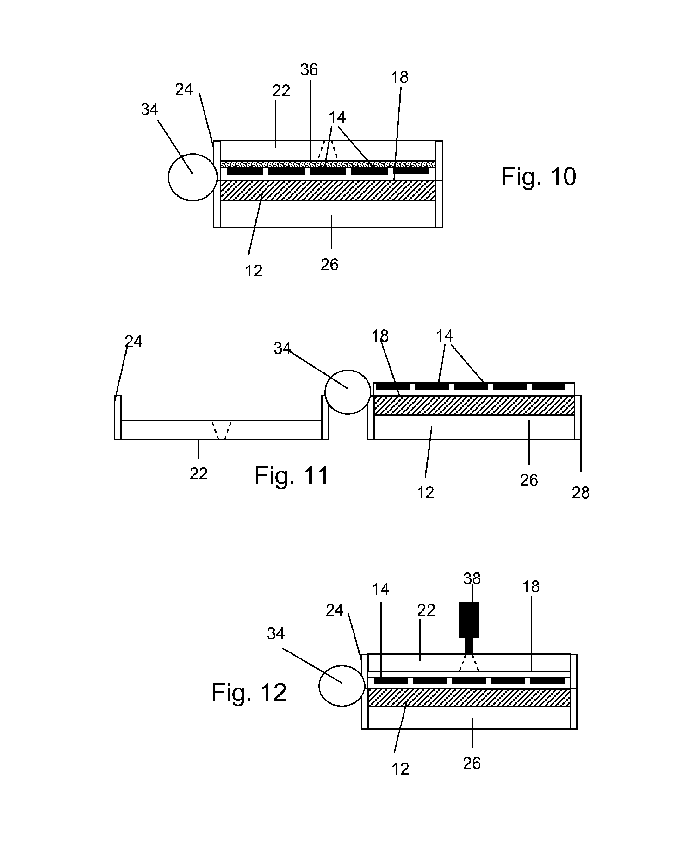

Nach dem zumindest teilweisen Aushärten wird die erste Formwerkzeughälfte 22 um 180° verschwenkt, so dass das durch überfluten der Photovoltaik-Zellen hergestellt Zwischenprodukt - wie auch bei der vorherigen Ausführungsform - auf der Trägerstruktur 12 zu liegen kommt (vgl. Fig. 10).

Nach dem Aufschwenken der Formwerkzeughälfte 26 wird die Zellenträgerplatte 36 entnommen (Fig. 11) wodurch der Anguss frei wird und die Oberflächenstruktur auf der (in Fig. 11) Oberfläche der Formwerkzeughälfte 22 exponiert ist. Nunmehr wird die Formwerkzeughälfte 26 wiederum zurückverschwenkt, wodurch sich aufgrund der nun fehlenden Zellenträgerplatte 36 eine im wesentlichen geschlossene Kavität ausbildet, deren Dicke der Dicke der Zellenträgerplatte entspricht. Dabei bildet die strukturierte Oberfläche nun die obere Kavitätswandung.

Durch den Anguss kann nun mit dem Mischkopf 38 das Polyurethan-Material in die Kavität eingefüllt werden, wodurch sich eine Beschichtung mit genau definierter Dicke und Oberflächenstruktur ausbildet.

Nach dem Öffnen des Formwerkzeugs kann das so hergestellte Solarmodul entnommen werden.

Mit der vorliegenden Verfahrensweise können auf einfache und schnelle Weise Solarmodule hergestellt werden, wobei die einzelnen Photovoltaik-Zellen beim Einbringvorgang des Polyurethanmaterials nicht beschädigt werden.

Wie vorgenannt erwähnt, verläuft das Polyurethanmaterial aufgrund der niedrigen Viskosität und des flüssigen Zustands flächig. Auch der Schwenkvorgang von Fig. 3 zu Fig. 4 ist insofern vorteilhaft, als etwaige Lufteinschlüsse in dem zunächst eingebrachten Polyurethanmaterial durch den Aufbringvorgang nach außen verdrängt werden. Wird dabei auch überschüssiges Material verdrängt, so kann dieses später beispielsweise durch einen Fräsvorgang oder einen Laserbeschnittvorgang abgetrennt werden.

Vorteilhaft ist insgesamt, dass mit dem beschriebenen Verfahren die Bruchgefahr beim Umschäumen der Matrizen eliminiert werden kann, da immer eine vollflächige Auflage gegeben ist. Die Solarmodule können nachfolgend ggf. noch mit einer Folie beschichtet werden, die die Sonnenstrahlen besser verwertet oder auch noch einen Schutz vor der Witterung bietet. Alternativ dazu kann die Oberfläche des Moduls auch durch eine Plasma-Funktionsschicht ergänzt werden, die neben der Schutzfunktion gegen Wasser und Schmutz auch Konzentratorwirkung haben kann. Beispielsweise kann so eine Wasseraufnahme des Polyurethanmaterials verhindert werden. Bei den Formwerkzeugen ist darauf zu achten, dass diese keine Haftung mit dem Polyurethanmaterial eingehen. Zu diesem Zweck könnten zumindest die mit dem Polyurethanmaterial in Verbindung kommenden Flächen aus Polypropylen gebildet sein. Zum Abtrennen von überflüssigem Material können auch Quetschkanten vorgesehen sein, die beim Verschwenkvorgang der einen Werkzeughälfte auf die andere zum Einsatz kommen. Auch ist es möglich, die Auflage auf der einen oder anderen Formwerkzeughälfte mittels einer elastischen Matte, beispielsweise einer Schaumstoffmatte auszuführen, über die zum einen das Vakuum zum Fixieren des Trägers aufgebracht werden kann. Zum anderen würde diese elastische Unterlage als "sanfter" Druckspeicher hinsichtlich des Trägers zum Polyurethan wirken und diesen mit einer gewissen Kraft an das Polyurethan andrücken.

### Bezugszeichenliste

- 10: Solarmodul
- 12: Trägerstruktur
- 14: Photovoltaik-Zellen
- 16: Verbindungsleitung
- 18: Polyurethanummantelung
- 18': Polyurethanschicht
- 20: Formwerkzeug
- 22: Erste Formwerkzeughälfte
- 24: Schalungsstruktur
- 26: Zweite Formwerkzeughälfte
- 28: Schalungsstruktur
- 28': Zusätzliche Schalungsstruktur
- 30: Aufnahme der zweiten Formwerkzeughälfte
- 32: Aufnahme der ersten Formwerkzeughälfte
- 34: Gelenk
- 36: Zellenträgerplatte
- 38: Polyurethan-Mischkopf
- 40: Kühlkanäle (Nuten)

## Patentansprüche

1. Verfahren zur Herstellung eines Solarmoduls mit den Schritten:
- Ausbilden einer Trägerstruktur (12),
- Ein- oder Aufbringen einer Temperiereinrichtung in die oder auf die Trägerstruktur,
- Aufbringen eines Zwischenproduktes mit Photovoltaik-Zellen auf die Trägerstruktur oder Eingießen der Temperiereinrichtung, derart, dass die Temperiereinrichtung einstrahlungsmäßig hinter den Photovoltaik-Zellen angeordnet sind.

2. **Verfahren nach Anspruch 1,**
**dadurch gekennzeichnet,**
**dass** in die den Solar-Zellen zugewandten Oberfläche der Trägerstruktur Kühlkanäle eingearbeitet werden.

3. Verfahren nach Anspruch 2,
**dadurch gekennzeichnet,**
**dass** die Kühlkanäle in Nuten der Trägerstruktur eingebracht werden.

4. Verfahren nach Anspruch 2 oder 3,
**dadurch gekennzeichnet,**
**dass** als Kühlkanäle dünne, fluiddichte Rohre eingebracht werden.

5. Vorrichtung zur Herstellung eines Solarmoduls, umfassend
ein Formwerkzeugteil (26) zum Positionieren einer Trägerstruktur (12), eine Einrichtung (34) zum Zusammenfügen zweier Formwerkzeugteile (22, 26), um das in einem vorherigen Schritt gewonnene Zwischenprodukt mit der Trägerstruktur (12) derart zusammenzufügen, dass sich die im Zwischenprodukt befindlichen Photovoltaik-Zellen (14) mit ihrer Rückseite der Trägerstruktur (12) zugewandt sind, wobei in der Trägerstruktur (12) oder auf der Trägerstruktur Temperiereinrichtungen (40) mit einem Temperierfluidzufluss und einem Temperierfluidabfluss vorgesehen sind.

6. Solarmodul umfassend
- eine Trägerstruktur,
- auf die Photovoltaik-Zellen aufgebracht sind,
- die in ein vernetzendes Material eingegossen sind,
- wobei in die oder auf die Trägerstruktur eine Temperiereinheit derart ein- oder aufgebracht ist, dass diese einstrahlungsmäßig hinter den Photovoltaik-Zellen angeordnet sind.

7. Solarmodul nach Anspruch 6,
**dadurch gekennzeichnet,**
**dass** in die den Photovoltaik-Zellen zugewandten Oberfläche der Trägerstruktur Kühlkanäle eingearbeitet oder auf die Trägerstruktur Kühlkanäle aufgebracht sind.

8. Solarmodul nach Anspruch 7,
**dadurch gekennzeichnet,**
**dass** die Kühlkanäle in Nuten der Trägerstruktur eingebracht sind.

9. Verfahren nach Anspruch 7 oder 8,
**dadurch gekennzeichnet,**
**dass** als Kühlkanäle dünne, fluiddichte Rohre verwendet sind.

10. Vorrichtung nach Anspruch 5,
**dadurch gekennzeichnet,**
**dass** die Temperiereinrichtung (40) zumindest teilweise von dem niedrig viskosen vernetzenden Material abgedeckt oder umhüllt ist.
